**Europäisches Patentamt**

**European Patent Office**

**Office européen des brevets**

(19)

(11) Veröffentlichungsnummer : **0 102 654**
**B1**

(12)

# EUROPÄISCHE PATENTSCHRIFT

(45) Veröffentlichungstag der Patentschrift :
**28.05.86**

(21) Anmeldenummer : **83201015.1**

(22) Anmeldetag : **07.07.83**

(51) Int. Cl.⁴ : **H 01 L 25/14**

(54) **Horizontalachsige Stromrichteranordnung.**

(30) Priorität : **10.09.82 CH 5388/82**

(43) Veröffentlichungstag der Anmeldung :
**14.03.84 Patentblatt 84/11**

(45) Bekanntmachung des Hinweises auf die Patenterteilung : **28.05.86 Patentblatt 86/22**

(84) Benannte Vertragsstaaten :
**CH DE FR LI SE**

(56) Entgegenhaltungen :
**DE-A- 1 914 790**
**DE-B- 1 276 209**

(73) Patentinhaber : **BBC Aktiengesellschaft Brown,
Boveri & Cie.**
**Haselstrasse**
**CH-5401 Baden (CH)**

(72) Erfinder : **Eckert, Heinz**
**Hauptstrasse 16**
**CH-5315 Böttstein (CH)**

**Beschreibung**

Die Erfindung bezieht sich auf eine horizontalachsige Stromrichteranordnung gemäss dem Oberbegriff des Anspruchs 1, wie sie beispielsweise aus der US-PS-3 447 118 bekannt ist.

Stromrichteranordnungen dieser Gattung eignen sich sowohl für Vertikal- als auch Horizontaleinbau. Während die Erstmontage beider Typen in der Regel keine besonderen Schwierigkeiten bietet, bereitet der nachträgliche Austausch von Kühlelementen und/oder Halbleiterbauelementen bei horizontalen Anordnungen z. T. komplizierte Hilfsvorrichtungen, damit beim Lösen der Spannmittel Halbleiterbauelemente oder Kühlelemente gesichert sind. Auch die gegenseitige Zentrierung und Justage beim Wiedereinbau erfordert grosse Aufmerksamkeit, ist zeitaufwendig und lässt sich oft nur mit Montagehilfseinrichtungen bewerkstelligen.

Bei der Stromrichteranordnung nach der US-PS-3 447 118, die offensichtlich für den vertikalen Einbau vorgesehen ist, erfolgt die gegenseitige Zentrierung von Halbleiterbauelementen und Kühlkörpern über besonders ausgebildete Kontaktflächen in Form von Kegelstümpfen. Sollen Halbleiterbauelemente und/oder Kühlkörper ausgewechselt werden, müssen nach Lösen der Spannmittel und Spannbolzen die oberhalb des auszuwechselnden Bauteils gelegenen Teile um mehr als das Doppelte der Höhe der genannten Kegelstümpfe angehoben und dort in ihrer Lage fixiert werden, bevor das auszuwechselnde Bauelement — sei es Halbleiterbauelement oder Kühlkörper entfernt werden kann. Noch komplizierter gestalten sich die Verhältnisse, wenn es sich um Kühlkörper mit Flüssigkeitskühlung handelt : Entweder müssen die Kühlmittelzu- und -ableitungen von den Kühlkörpern entfernt oder in ihrer Länge so bemessen werden, dass eine Verschiebung in Säulenlängsrichtung entsprechender Grösse ermöglicht wird.

Gleiches gilt für Stromrichteranordnung dieses Typs mit horizontaler Säulenachse. Dann sind Demontage- und Montage-Hilfsvorrichtungen unentbehrlich. Darüber hinaus eignet sich die bekannte Anordnung nicht für sogenannte Scheibenzellen, wie sie z. B. in der US-PS-3 661 013 beschrieben und dargestellt sind. Bei dieser Stromrichteranordnung ist ein einziges Halbleiterbauelement zwischen zwei Spannplatten eingespannt. Zur Zentrierung und Justierung des Halbleiterbauelementes gegenüber den beiden Spannplatten sind Zentrierstifte vorgesehen, welche in entsprechende Bohrungen in den Kontaktflächen des Halbleiterbauelements und der Spannplatten eingreifen. Obwohl in dieser Patentschrift nicht ausdrücklich dargestellt, eignet sich die bekannte Anordnung auch für zu einer Säule aufeinandergestapelte Halbleiterbauelemente. Bezüglich Demontage und Montage gelten die gleichen Ausführungen, wie sie im Zusammenhang mit der US-PS-3 447 118 gemacht wurden.

Beiden bekannten Anordnungen haftet darüber hinaus der Nachteil an, dass auch die Erstmontage, falls sie aus konstruktiven Gegebenheiten nur mit horizontaler Säulenachse erfolgen kann, aufwendige Hilfsvorrichtungen erfordert.

Ausgehend vom geschilderten Stand der Technik liegt der Erfindung die Aufgabe zugrunde, an horizontalachsigen Stromrichteranordnungen ein kostengünstiges und einfach handzuhabendes Montage- und Demontage-Hilfsmittel zu schaffen, das sowohl bei der Erstmontage als auch bei Reparatur und Service eine zuverlässige Abstützung der Halbleiterbauelemente und/oder Kühlelemente und deren gegenseitige Zentrierung und Justierung ermöglicht.

Die Lösung dieser Aufgabe erfolgt erfindungsgemäss durch die Merkmale des Anspruchs 1.

Die mit der Erfindung erzielbaren Vorteile sind in folgendem zu sehen :

Bezugsbasis für Zentrierung und Justage sind die Spannbolzen. Bei der Erstmontage und auch beim Wiedereinbau eines Ersatzteiles (Halbleiterbauelement und/oder Kühlelement) bilden das oder die Abstützteile eine Einbaulehre, die jedoch — weil wirtschaftlich herzustellen — am Einbauort verbleiben kann. Art und Ausbildung der mit dem einzubauenden Bauteil zusammenwirkenden Kanten und Flächen lassen sich in einfacher Weise verschiedenen Bauteilabmessungen anpassen, zumal Halbleiterbauelemente und Kühlelemente in ihren mechanischen Dimensionen weitgehend standardisiert sind. Dies erfordert für unterschiedliche Stromrichteranordnungen nur einige wenige Typen von Abstützteilen.

Bei der Demontage bieten die Abstützteile eine zuverlässige Sicherung, da sie das Gewicht der beiden Säulenteile beidseits des auszuwechselnden Bauteils aufnehmen.

Die abhängigen Ansprüche 2 bis 8 beinhalten zweckmässige Weiterbildungen des Erfindungsgegenstandes.

Die Ausbildung des Abstützteils nach Anspruch 2 sichert die Lage des Abstützteils in der Ebene der Spannbolzen. Schaltet man gemäss Anspruch 3 elastische Glieder zwischen den Zentral- und Endteil oder bildet die Auflage auf den Spannbolzen elastisch aus, so lassen sich eventuelle Setzerscheinungen beim Verspannen der Halbleitersäule ausgleichen, ohne dass die Abstützteile diese behindern.

Das vorzugsweise als Guss- oder Spritzgussteil aus Isoliermaterial bestehende Abstützteil ist zweckmässig einstückig ausgeführt. Die mit den Bezugsflächen bzw. -kanten von Halbleiterbauelement und Kühlelement zusammenwirkenden Stege lassen sich den jeweiligen konstruktiven Gegebenheiten leicht anpassen, gegebenenfalls bei Toleranzabweichungen nacharbeiten. Die Stege beeinträchtigen die Potentialtrennung zwischen den beiden Kontaktflächen des Halbleiterbauelements nur geringfügig und wirken sich nicht störend auf die Wärmeabfuhr aus, was insbesondere bei Luftkühlung von Bedeutung ist.

Prinzipiell ist es möglich, das Abstützteil so auszubilden, dass nur die beiden benachbarten Kühlelemente abgestützt und zentriert bzw. justiert werden, oder dass jeweils nur das Halbleiterbauelement abgestützt und zentriert bzw. justiert wird. Bei Stromrichteranordnungen mit Flüssigkeitskühlung (der Kühlelemente) wäre dies insofern realisierbar, als die zu den Kühlelementen führenden Kühlmittelleitungen selbst eine gewisse Abstützung und Justierung bewirken. Der volle Vorteil der Erfindung entfaltet sich jedoch bei Ausbildung des Abstützteils mit mindestens drei Stegen nach Anspruch 5. Dies gilt insbesondere für die Erstmontage, wo zunächst die Halbleitersäule mit Kühlelementen und erst danach die Kühlmittelleitungen montiert werden. Der oder die mittleren Stege des Abstützteils sind den Bezugsflächen oder -kanten des Halbleiterbauelements angepasst und greifen vorzugsweise in die Rillen des Isolators ein. Dies bringt den zusätzlichen Vorteil der Justierung in Säulenlängsrichtung. Durch Anschläge an den seitlichen Enden der beiden äusseren Stege werden die Kühlelemente auch in der durch die beiden Spannbolzen bestimmten Ebene justiert.

Es versteht sich von selbst, dass das Abstützteil auch aus mehreren Einzelteilen bestehen kann. So können z. B. die Stege auf den Zentralteil des Abstützteiles aufgesteckt sein, oder für Kühlelemente und Halbleiterbauelemente sind getrennte Abstützteile mit entsprechenden Stegen vorgesehen.

Die Erfindung wird nachstehend anhand eines in der Zeichnung dargestellten Ausführungsbeispiels näher erläutert.

In der Zeichnung zeigt

Figur 1 die Seitenansicht eines Teils einer horizontalachsigen Stromrichteranordnung ;

Figur 2 einen Schnitt durch die Stromrichteranordnung gemäss Fig. 1 längs deren Linie AA ;

Figur 3 eine perspektivische Darstellung eines Abstützgliedes.

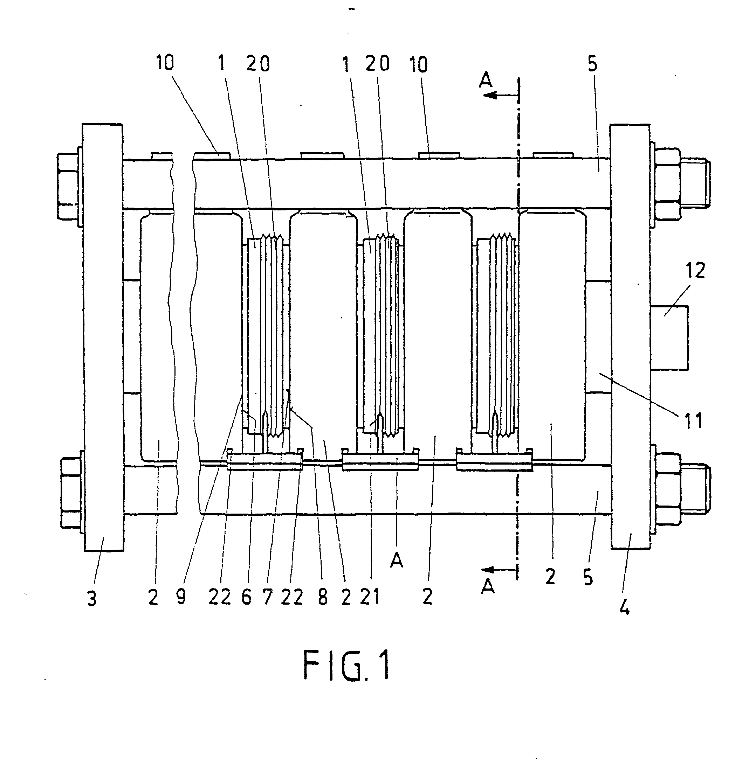

In Fig. 1 sind eine Vielzahl von scheibenförmigen Halbleiterbauelementen 1 mit dazwischengeschalteten Kühlelementen 2 zwischen zwei äusseren Spannplatten 3, 4 mittels Spannbolzen 5 eingespannt. Die Halbleiterbauelemente 1 weisen planparallele Kontaktflächen 6, 7 auf, welche mit den gleichfalls planparallelen Kontaktflächen 8, 9 der Kühlelemente 2 zusammenwirken. Die Kühlelemente 2 sind in bekannter Weise als sogenannte Kühldosen ausgebildet. Zu- und Abfuhr des Kühlmittels erfolgt über Kühlmittelanschlussstutzen 10. Nicht eingezeichnet sind elektrisch isolierende Kühlmittelverbindungsschläuche, welche zu einem gleichfalls nicht dargestellten Kühlmittelverteiler oberhalb der Halbleitersäule führen. Zwischen dem äussersten Kühlelement und der Spannplatte 4 ist ein Tellerfederpaket 11 angeordnet. Ueber eine schematisch angedeutete Spanneinrichtung 12 lässt sich eine definierte Spannkraft auf die mechanisch in Serie geschalteten Halbleiterbauelemente und Kühlelemente einleiten. Als Spanneinrichtung kann beispielsweise eine solche verwendet werden, wie sie in der eingangs genannten US-PS-3 447 118 ausführlich beschrieben ist.

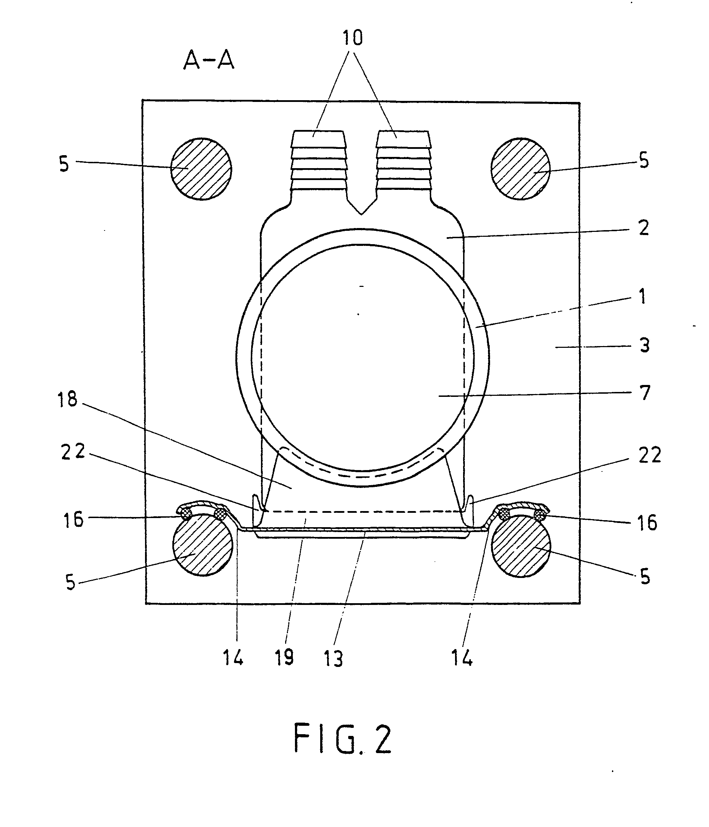

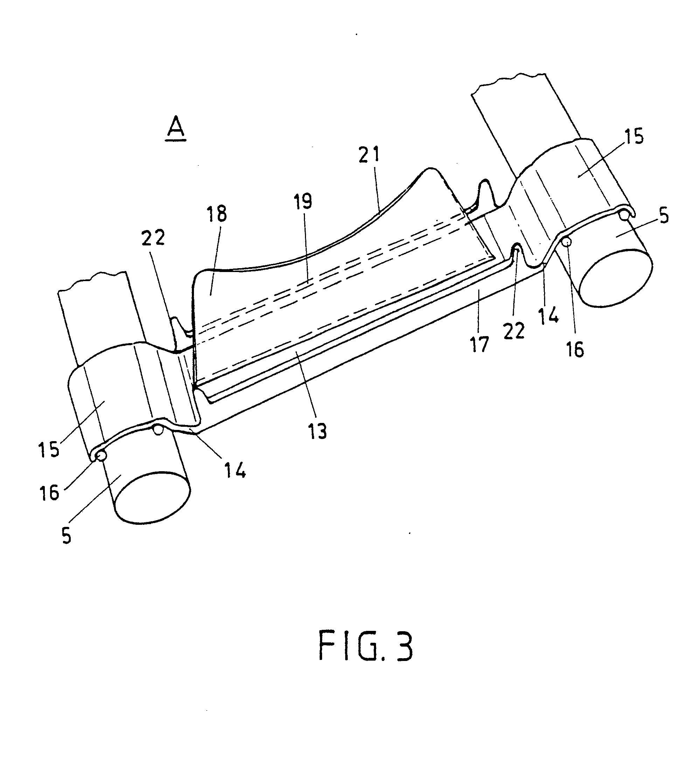

Jeweils unterhalb von zwei benachbarten Kühlelementen 2 ist ein Abstützteil A angeordnet, dessen Aufbau in Fig. 2 und Fig. 3 deutlicher zu erkennen ist. Seine Breite in Säulenlängsrichtung ist grösser als der Abstand zweier benachbarter Kühlelemente 2. Der Abstützteil A weist einen flachen Zentralteil 13, zwei elastische Zwischenteile 14 und zwei Endteile 15 auf. Die beiden Endteile sind aus der Ebene des Zentralteils 13 herausgebogen und umfassen teilweise die beiden Spannbolzen 5. Zwischen den beiden Endteilen 15 und den Spannbolzen 5 sind elastische Zwischenlagen 16 in Form zylindrischer Gummistäbe angeordnet. Auf dem Zentralteil 13 sind drei in Richtung des Halbleiterbauelements bzw. der Kühlelemente weisende Stege 17, 18, 19 vorgesehen, die vorzugsweise einstückig mit dem Zentralteil 13 ausgebildet sind. Die beiden äusseren Stege 17 und 19 dienen der Abstützung der Kühlelemente 2 beidseits des Halbleiterbauelements 1. Der mittlere Steg 18 weist eine konkave, der Peripherie des Isolatorgehäuse 20 des Halbleiterbauelements 1 angepasste Stirnfläche auf. Der Steg 18 läuft in einer Art Schneide 21 aus, die in eine Rille des Isolatorgehäuses 20 eingreift. Die spannbolzenseitigen Enden der Stege 17 und 19 sind mit Anschlägen 22 versehen. Der Abstützteil ist vorzugsweise aus Isoliermaterial, z. B. Polyester oder GFK, und beispielsweise im Spritzguss- oder Formpressverfahren hergestellt.

Die Wirkungsweise der Erfindung ergibt sich nachfolgend aus der Beschreibung der wesentlichen Phasen der Erstmontage und des Auswechsels eines Halbleiterbauelements und/oder Kühlelements der Halbleitersäule.

Ausgehend von einer Anordnung mit beidseitigen Spannplatten 3, 4 und Spannbolzen 5 werden die Abstützteile A unter Zwischenschaltung der elastischen Zwischenlage 16 auf die Spannbolzen 5 aufgelegt. Sukzessive werden abwechselnd Kühlelemente 2 und Halbleiterelemente 1 seitlich oder von oben eingelegt. Die Stege 17, 18 und 19 stützen diese Bauteile ab, zentrieren sie gegenseitig und justieren sie in Richtung quer zur Säulenachse (Anschläge 22 für die Kühlelemente 2, konkave Stirnfläche des Steges 18 für das Halbleiterbauelement). Die Justierung in Säulenlängsrichtung ergibt sich durch die feste Zuordnung der axialen Lage von Steg 18 und den Rillen des Isolatorgehäuses. Nach dem Einsetzen aller Bauteile wird die Spanneinrichtung 12 aktiviert und die gewünschte Spannkraft auf die Halbleitersäule ausgeübt. Eventuell auftretende Setzerscheinungen in Richtung quer zur Säulenlängsachse werden durch die elastischen Zwischenlagen und/oder die elastischen Zwischenteile 14 der Abstützteile A aufgenommen, so dass von diesen keine nennenswerten störenden Kräfte auf die Halbleitersäule ausgeübt werden. Die Abstützteile verbleiben am Einbauort. Sie beeinflussen die Potentialtrennung zwi-

# 0 102 654

schen den beiden Kontakten 6, 7 des Halbleiterbauelements nicht.

Im Falle eines Austausch eines Bauteils der Halbleitersäule — sei es ein Halbleiterbauelement, sei es ein Kühlelement — wird nach Lösen der Spanneinrichtung 12 und nach eventuellem Auseinanderdrücken der dem auszutauschenden Bauteil benachbarten Bauteile das auszuwechselnde Bauteil seitlich oder nach oben hin entfernt. Alle anderen Bauteile werden dabei sicher durch die Abstützteile gehalten. Nach erfolgtem Austausch wird die Spanneinrichtung wieder aktiviert. Aus den vorstehenden Ausführungen erhellt ein wesentlicher Vorteil des Erfindungsgegenstandes gegenüber den herkömmlichen Anordnungen : Bei betriebsmässig eingebauten Halbleitersäulen ist in der Regel die Lage der Spannplatten 3, 4 fest vorgegeben. Die Vergrösserung des gegenseitigen Abstandes zwischen den Spannplatten allein zum Zweck des Austauschs eines Bauelements der Halbleitersäule gestaltet sind infolge der Zentriermittel zeitaufwendig. Beim Erfindungsgegenstand hingegen genügt allein das Lösen der Spanneinrichtung, die aus konstruktiven Erwägungen heraus nur geringe Betätigungswege ermöglicht, zur Schaffung des notwendigen « Spiels » zur Entnahme und Montage eines Bauelements.

Der Erfindungsgegenstand lässt selbstverständlich auch andere Gehäuseformen der Halbleiterbauelemente und andere Formen des Kühlelements zu als sie im vorstehenden beschrieben wurden. Hierzu bedarf es lediglich Aenderungen hinsichtlich der Geometrie der Stege 17, 18, 19. Auch kann zumindest der mittlere Steg 18 als separates Bauteil, das in den Zentralteil 13 einsteckbar ist, ausgebildet sein. Es liegt auch im Rahmen der Erfindung, die Abstützteile A z. B. zweiteilig auszubilden, deren Trennfläche in Steglängsrichtung durch den Steg 18 verläuft.

Es versteht sich, dass anstelle von Flüssigkeitskühlung auch Luftkühlung angewandt werden kann, wozu lediglich die mit den Luftkühlern zusammenwirkenden Stege 17, 19 angepasst werden müssen.

## Patentansprüche

1. Horizontalachsige Stromrichteranordnung mit einer Mehrzahl von mechanisch in Reihe geschalteten Halbleiterbauelementen (1) mit planparallelen Kontaktflächen (6, 7) und mit zwischen wenigstens einige der Halbleiterbauelemente zwischengeschalteten Kühlelementen (2) mit gleichfalls planparallelen Kontaktflächen (8, 9), welche Halbleiterbauelemente (1) und Kühlelemente (2) zwischen zwei äusseren Spannteilen (3, 4) mittels Spannbolzen (5) eingespannt sind, und mit Mitteln (A) zur gegenseitigen Zentrierung und Justierung der gegenseitigen Lage von Halbleiterbauelementen (1) und Kühlelementen (2), dadurch gekennzeichnet, dass im Bereich unterhalb zweier benachbarter Kühlelemente (2) ein Abstützteil (A) vorgesehen ist, der sich auf zwei horizontal benachbarten Spannbolzen (5) abstützt, und dass das Abstützteil Zentrier- bzw. Justierkanten und/oder -flächen (17, 18, 19) aufweist, welche gegen das Halbleiterbauelement (1) und das Kühlelement (2) weisen, und zur zumindest zeitweiligen Abstützung von Halbleiterbauelement und/oder Kühlelement dienen.

2. Stromrichteranordnung nach Anspruch 1, dadurch gekennzeichnet, dass das Abstützteil (A) aus einem Zentralteil (13) und zwei die Spannbolzen (5) zumindest teilweise umgreifenden Endteilen (15) besteht.

3. Stromrichteranordnung nach Anspruch 2, dadurch gekennzeichnet, dass zwischen dem Zentralteil und dem Endteil ein elastisches Zwischenteil (14) oder zwischen dem Endteil (15) und den Spannbolzen (5) elastische Zwischenlagen (16) vorgesehen sind.

4. Stromrichteranordnung nach Anspruch 2 oder 3, dadurch gekennzeichnet, dass auf dem Zentralteil (13) mindestens ein vorzugsweise mit diesem einstückig ausgeführter, quer zur Säulenlängsachse verlaufender Steg (18) vorgesehen ist, der mit den Bezugskanten bzw. -flächen von Halbleiterbauelement (1) und/oder Kühlelement (2) zusammenwirkt.

5. Stromrichteranordnung nach Anspruch 4, dadurch gekennzeichnet, dass mindestens drei Stege (17, 18, 19) vorgesehen sind, von denen die beiden äusseren (17, 19) der Peripherie der Kühlelemente (2), der oder die mittleren (18) der Peripherie des Halbleiterbauelements (1) angepasst sind.

6. Stromrichteranordnung nach Anspruch 5, dadurch gekennzeichnet, dass die äusseren Stege (17, 19) mit Anschlägen (22) versehen sind, deren Abstand annähernd der Breite des Kühlelementes (2) entspricht, und dass der oder die mittleren Stege (18) eine der äusseren Peripherie des Halbleiterbauelements angepasste Aussparung aufweist.

7. Stromrichteranordnung nach einem der Ansprüche 4 bis 6, dadurch gekennzeichnet, dass der mittlere Steg (18) auf dem dem Zentralteil (13) abgewandten Ende in eine Schneide (21) ausläuft.

8. Stromrichteranordnung nach einem der Ansprüche 4 bis 6, dadurch gekennzeichnet, dass der mittlere Steg (18) auf der dem Zentralteil (13) abgewandten Stirnseite mit einer Nut versehen ist.

## Claims

1. Static converter arrangement with horizontal axis, comprising a plurality of semi-conductor components (1) mechanically connected in series and having plane-parallel contact surfaces (6, 7) and comprising cooling elements (2) connected between at least some of the semi-conductor components and having contact surfaces (8, 9) which are also plane-parallel, which semi-conductor components (1) and cooling elements (2) are clamped by means of clamping bolts (5) between two outer clamping parts (3, 4), and comprising means (A) for the mutual centring and aligning of the mutual position of semi-conductor components (1) and cooling elements (2), characterized in that a support part (A) resting on two horizontally adjacent clamping bolts (5) is provided in the area below two adjacent cooling elements (2) and that the support part has centring and aligning edges and/or surfaces (17, 18, 19) which point towards the semi-conductor component (1) and the cooling element (2) and are used for the at least temporary support of semi-conductor component and/or cooling element.

2. Static converter arrangement according to Claim 1, characterized in that the support part (A) consists of a central part (13) and two end parts (15) which at least partially encompass the clamping bolts (5).

3. Static converter arrangement according to Claim 2, characterized in that an elastic intermediate part (14) is provided between the central part and the end part or elastic spacers (16) are provided between the end part (15) and the clamping bolts (5).

4. Static converter arrangement according to Claim 2 or 3, characterized in that at least one bridge (18) is provided on the central part (13), which bridge is preferably constructed of one piece with the central part and extends transversely to the longitudinal axis of the column and which acts in conjunction with the reference edges or surfaces of semi-conductor component (1) and/or cooling element (2).

5. Static converter arrangement according to Claim 4, characterized in that at least three bridges (17, 18, 19) are provided, the two outer (17, 19) bridges of which are matched to the periphery of the cooling elements (2) and the central bridge or bridges (18) of which are matched to the periphery of the semi-conductor component (1).

6. Static converter arrangement according to Claim 5, characterized in that the outer bridges (17, 19) are provided with stops (22) the distance of which approximately corresponds to the width of the cooling element (2) and that the central bridge or bridges (18) has a recess which matches the outer periphery of the semi-conductor component.

7. Static converter arrangement according to one of Claims 4 to 6, characterized in that the central bridge (18) ends in a knife edge (21) on the end facing away from the central part (13).

8. Static converter arrangement according to one of Claims 4 to 6, characterized in that the central bridge (18) is provided with a groove on the face facing away from the central part (13).

## Revendications

1. Dispositif redresseur à axe horizontal comportant une pluralité de composants semiconducteurs (1) montés mécaniquement en série, avec des surfaces de contact (6, 7) planes parallèles et, entre au moins quelques-uns des composants semiconducteurs, des éléments de refroidissement (2) avec des surfaces de contact (8, 9) pareillement planes et parallèles, lesquels composants semiconducteurs (1) et éléments de refroidissement (2) sont serrés entre deux plaques de serrage (3, 4) extérieures au moyen de boulons de serrage (5), et avec des moyens (A) pour assurer le centrage et l'ajustage relatifs de la position relative des composants semiconducteurs (1) et des éléments de refroidissement (2), caractérisé en ce que, dans la région située sous deux éléments de refroidissement (2) voisins, il est prévu une pièce d'appui (A) qui prend appui sur deux boulons de serrage (5) horizontaux voisins, et en ce que la pièce d'appui présente des arêtes et/ou des surfaces de centrage et/ou d'ajustage (17, 18, 19), qui sont dirigées vers le composant semiconducteur (1) et vers l'élément de refroidissement (2) et servent pour l'appui au moins temporaire du composant semiconducteur et/ou de l'élément de refroidissement.

2. Dispositif redresseur suivant la revendication 1, caractérisé en ce que la pièce d'appui (A) se compose d'une partie centrale (13) et de deux parties terminales (15) entourant au moins partiellement les boulons de serrage (5).

3. Dispositif redresseur suivant la revendication 2, caractérisé en ce qu'entre la partie centrale et la partie terminale, il est prévu une partie intermédiaire (14) élastique ou entre la partie terminale (15) et les boulons de serrage (5) il est prévu des couches intermédiaires (16) élastiques.

4. Dispositif redresseur suivant la revendication 2 ou 3, caractérisé en ce que, sur la partie centrale (13), il est prévu au moins une ailette (18) réalisée de préférence en une seule pièce avec elle et orientée transversalement à l'axe longitudinal de la colonne, ailette qui coopère avec les arêtes, respectivement avec les surfaces de référence du composant semiconducteur (1) et/ou de l'élément de refroidissement (2).

5. Dispositif redresseur suivant la revendication 4, caractérisé en ce qu'il est prévu au moins trois ailettes (17, 18, 19), dont les deux extérieures (17, 19) sont adaptées au contour des éléments de refroidissement (2) et la ou les ailettes médianes (18) est/sont adaptée(s) au contour du composant semiconducteur (1).

6. Dispositif redresseur suivant la revendication 5, caractérisé en ce que les ailettes extérieures (17, 19) sont pourvues de butées (22), dont l'écartement correspond approximativement à la largeur de l'élément de refroidissement (2), et en ce que la ou les ailettes médianes (18) présentent un creux adapté au contour extérieur du composant semiconducteur.

7. Dispositif redresseur suivant l'une ou l'autre des revendications 4 à 6, caractérisé en ce que l'ailette médiane (18) se termine, à son extrémité opposée à la partie centrale (13), par une lame (21).

8. Dispositif redresseur suivant l'une ou l'autre des revendications 4 à 6, caractérisé en ce que l'ailette médiane (18) est pourvue d'une rainure dans sa face terminale opposée à la partie centrale (13).

FIG.1

FIG. 2

FIG. 3